# EUROPÄISCHE PATENTSCHRIFT

(11) **EP 0 282 646 B1**
(45) Veröffentlichungstag und Bekanntmachung des Hinweises auf die Patenterteilung: **24.03.1993**
(21) Anmeldenummer: 87117942.0
(22) Anmeldetag: 04.12.1987
(51) Int. Cl.: H01F 15/10

(54) **Ferritkernspule mit mehr als zwei Spulenanschlüssen für Reflow-Lötung auf einer Leiterplatte**
Ferrite core coil with more than two coil tags for reflow soldering on a printed-circuit board
Bobine à noyaux de ferrite à plus de deux contacts de bobine pour soudage Reflow sur une plaquette de circuit imprimé

(30) Priorität: 18.03.1987 DE 3708742
(43) Veröffentlichungstag der Anmeldung: 21.09.1988
(73) Patentinhaber: ROBERT BOSCH GMBH, 70442 Stuttgart (DE)
(72) Erfinder: Beyer, Klaus, D-1000 Berlin 48 (DE); Meissner, Udo, Dipl.-Ing., D-1000 Berlin 37 (DE)

(56) Entgegenhaltungen:
- EP-A- 0 175 461
- DE-A- 3 232 533
- GB-A- 2 080 044
- US-A- 4 498 067

## Beschreibung

Die Erfindung betrifft eine Ferritkernspule nach dem Oberbegriff des Anspruchs 1. Um die Serienherstellung von mit eletrischen Bauteilen bestückten Leiterplatten zu rationalisieren, werden sogenannte SMD(Surface Mounted Devices)-Bauteile verwendet, deren verzinnte Anschlüsse auf Kontaktflächen von Leiterbahnen einer Leiterplatte passen. Durch Erwärmung der Kontaktstelle wird dann das Lötzinn flüssig, so daß die Anschlüsse und die Kontaktflächen nach dem Abkühlen der Kontaktstelle dauerhaft leitend miteinander verbunden sind.

### Stand der Technik

Es sind Ferritkernspulen in SMD-Technik bekannt (Druckschrift "Applying Chip Inductors" der Firma Coilcraft, Cary, Illinois/USA), bei denen der eine Spulenwicklung tragende quaderförmige Ferritkern an der Unterseite zwei mit einer Lötzinnschicht versehene Füße aufweist. Jedes Drahtende der Wicklung ist mit einer Lötzinnschicht an den Füßen verbunden. Sobald die Spulen mehr als zwei Anschlüsse aufweisen, benötigen sie bisher einen zusätzlichen Tragkörper zum Beispiel in Form einer Platte oder eines Quaders, der die Anschlüsse auf seiner Unterseite trägt.

Aus der DE-A-32 32 533 ist weiterhin eine Chip-Spule bekannt, die zum Anschließen von mehr als Zwei Spulendrahtenden nicht geeignet ist, weil ihre Elektroden elektrisch leitende Metalldrähte sind, die zum Beispiel ein drittes, um einen der Metalldrähte gewickeltes Spulendrahtende mit dem auf demselben Metalldraht befindlichen anderen Spulendrahtende galvanisch verbinden würde. Eine Spuleneinheit nach der GB-A-2 080 044 besteht aus zwei Einzelteilen, nämlich aus einem Spulenkörper für den Spulendraht und einem den Spulenkörper zur Hälfte umgebenden halbrohrförmigen Ferritteil.

### Aufgabe

Der Erfindung liegt die Aufgabe zugrunde, eine Ferritkernspule mit mehr als zwei Spulenanschlüssen für die Reflow-Lötung zu realisieren, die ohne ein zusätzliches Halterungselement auskommt sowie einfach herstellbar und montierbar ist.

### Lösung

Diese Aufgabe wird bei einer gattungsgemäßen Ferritkernspule durch die kennzeichnenden Merkmale des Anspruchs 1 gelöst.

### Erzielbare Vorteile

Der mit der Erfindung erzielbare Vorteil besteht insbesondere darin, daß auch bei mehr als zwei Spulenanschlüssen kein zusätzliches Bauteil als Träger für den Ferritkern und die lötfähigen Anschlüsse erforderlich ist. Als weiterer Vorteil ist anzusehen, daß bei der Ferritkernspule keine besonderen Lötflächen zum Anschließen der Spulendrahtenden und zur Reflow-Lötung erforderlich sind, denn beispielsweise brauchen die Vorsprünge des Ferritkerns lediglich mit Lötpaste versehen zu werden, so daß der Lack des üblicherweise verwendeten und um die Vorsprünge gewickelten Kupferdrahtes beim Reflowlöten verdampft. Vorteilhaft ist auch noch, daß durch ein mehrfaches Umwickeln der Vorsprünge mit den Spulendrahtenden ein mechanisch und elektrisch stabiler Anschluß erzielt wird.

Ein bevorzugtes Anwendungsgebiet für die Erfindung sind Verteiler und Abzweiger für Kabelfernsehanlagen.

### Beschreibung von Ausführungsbeispielen

Ausführungsbeispiele der Erfindung sind in der Zeichnung dargestellt und werden im folgenden näher beschrieben. Es zeigen
- Fig. 1: eine perspektivische Ansicht einer auf einer Leiterplatte befestigten erfindungsgemäßen quaderförmigen Ferritkernspule in vergrößertem Maßstab,
- Fig. 2: eine perspektivische Ansicht einer hohlzylindrischen Ferritkernspule, die in einem Ausschnitt einer Leiterplatte befestigt ist, und
- Fig. 3: eine perspektivische Ansicht einer Ferritkernspule mit Doppellochkern.

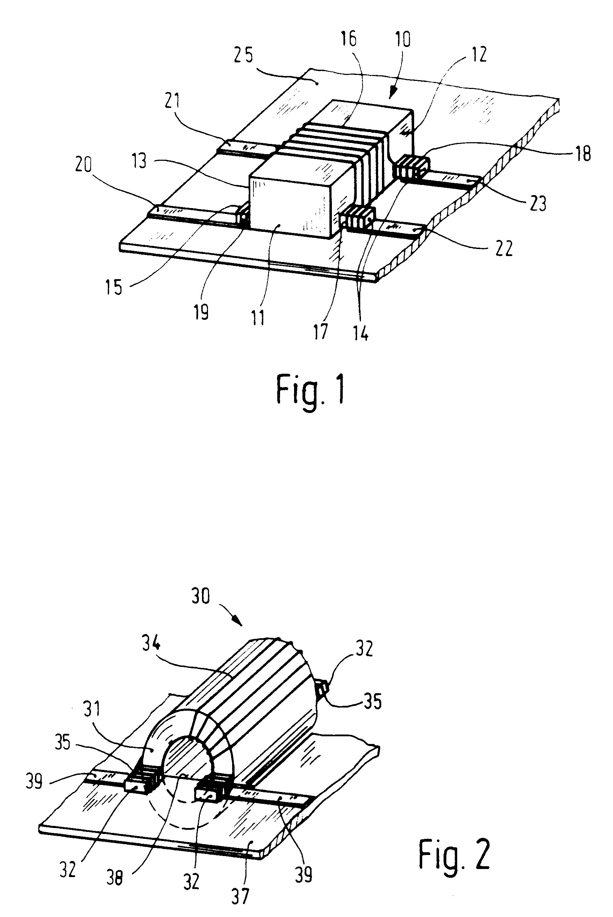

In Fig. 1 ist eine Ferritkernspule 10 mit einem quaderförmigen Ferritkern 11 gezeigt, der an zwei gegenüberliegenden längeren Schmalseiten 12, 13 je zwei Vorsprünge 14, 15 trägt. Die Vorsprünge sind einstückig mit dem Ferritkern hergestellt. Die Unterseite der Vorsprünge liegt vorzugsweise in derselben Ebene wie die Unterseite des Ferritkerns. Der Ferritkern 11 ist mit einer Spule 16 bewickelt, deren Drahtenden um die Vorsprünge 14, 15 herumgewickelt sind und Spulenanschlüsse 17, 18, 19 bilden.

Die Ferritkernspule 10 ist beispielsweise ein Übertrager mit vier Spulenanschlüssen. Nach Fig. 1 liegt die Ferritkernspule mit ihren Spulenanschlüssen 17, 18, 19 auf je einem Endbereich einer Leiterbahn 20 bis 23 einer Leiterplatte 25. Auf diese Endbereiche wird zuvor vorzugsweise per Siebdruck Lötpaste aufgetragen. Durch Erwärmen der wärmebeständigen Leiterplatte 25 wird die Lötpaste flüssig, der Lack des Spulendrahtes verdampft, und nach dem Erkalten liegt eine elektromechanische Lötverbindung zwischen den genannten Teilen vor. Bei einer anderen Ausführungsart der Lötverbindung werden die Vorsprünge 14, 15 mit der Lötpaste bestrichen.

In Fig. 2 bezeichnet 30 eine Ferritkernspule mit einem hohlzylindrischen Ferritkern 31, der mit vier in einer diametralen Ebene liegenden, vorzugsweise stirnseitigen Vorsprüngen versehen ist, von denen in der Fig. 2 nur drei Vorsprünge 32 gezeigt sind. Der Ferritkern 31 trägt eine Spule 34, deren Drahtenden als Spulenanschlüsse 35 um die Vorsprünge 32 gewickelt sind. Eine Leiterplatte 37 enthält eine rechteckige Ausnehmung 38, die derart bemessen ist, daß die Ferritkernspule 30 hineinpaßt, wobei sich die Vorsprünge 32 bzw. die Spulenanschlüsse 35 auf entsprechenden Endbereichen von Leiterbahnen 39 abstützen. Die Kontaktierung erfolgt beispielsweise wie bei dem Ausführungsbeispiel nach Fig. 1.

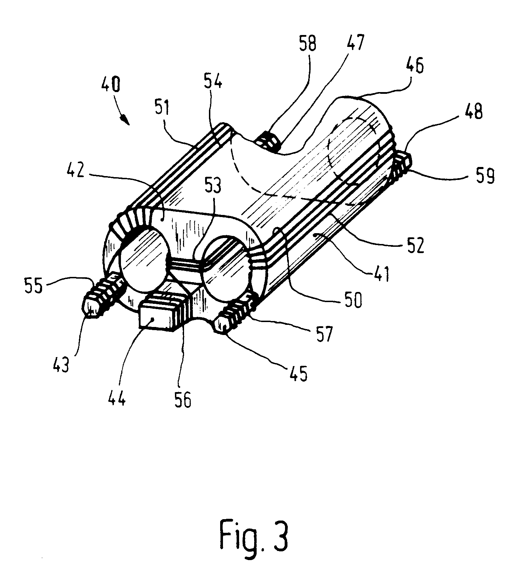

In Fig. 3 bezeichnet 40 eine Ferritkernspule mit einem Doppelloch-Ferritkern 41. Der Doppelloch-Ferritkern weist an seiner vorderen Stirnseite 42 drei Vorsprünge 43, 44, 45 und an seiner hinteren Stirnseite 46 zwei Vorsprünge 47, 48 auf. Die Vorsprünge befinden sich an der Unterseite des Ferritkerns 41 und schließen bündig mit dessen Unterkante ab.

Der Ferritkern trägt eine Spule mit vier Wicklungen 51, 52, 53, 54, die zu einem Breitbandübertrager zusammengeschaltet sind. Die Spulenanschlüsse der Wicklungen sind mit 55 bis 59 bezeichnet. Die Kontaktierung zwischen den Spulenanschlüssen und entsprechenden Leiterbahnen einer Leiterplatte erfolgt auf die gleiche Weise wie bei dem Ausführungsbeispiel nach Fig. 1.

## Patentansprüche

1. Ferritkernspule mit mehr als zwei Spulenanschlüssen (17-19), wobei die zu den Spulenanschlüssen (17-19) führenden Drahtenden der Spule (16) um am Umfang des Ferritkerns (11) vorhandene, in einer Ebene liegende Vorsprünge (14,15) gewickelt sind und wobei die Vorsprünge (14,15) zusammen mit den Drahtenden die Spulenanschlüsse (17-19) bilden, die durch Reflow-Lötung mit Leiterbahnen (20-23) einer Leiterplatte (25) verbindbar sind, **dadurch gekennzeichnet,** daß die Vorsprünge (14, 15) einstückig mit dem Ferritkern (11) hergestellt sind.

2. Ferritkernspule nach Anspruch 1, dadurch gekennzeichnet, daß bei einem quaderförmigen Ferritkern (11) oder einem Doppelloch-Ferritkern (41) die Vorsprünge (14, 43) stirnseitig an der Unterseite des Ferritkerns angeordnet sind.

3. Ferritkernspule nach Anspruch 1, dadurch gekennzeichnet, daß bei einem quaderförmigen, hohlzylindrischen oder Doppelloch-Ferritkern (11, 31, 41) die Vorsprünge in der horizontalen Symmetrieebene des Ferritkerns liegen und daß eine Leiterplatte (37) eine Ausnehmung (38) zur Aufnahme des Ferritkerns und Leiterbahnen (39) aufweist, die unterhalb der Spulenanschlüsse (35) der Spulenwicklung (34) enden.

## Claims

1. A ferrite core coil having more than two coil tags 17 - 19 and the wire ends, of the coil 16, which are to be directed to the coil tags 17 - 19, are wound around projections 14, 15 lying in one plane at the periphery of the ferrite core 11 and the projections 14, 15 together with the wire ends form the coil tags 17 - 19, which can be reflow soldered to strip conductors 20 - 23 on a printed circuit board 25, characterised in that the projections 14, 15 are manufactured in one piece with the ferrite core 11.

2. A ferrite core coil as claimed in claim 1, characterised in that with a cuboid ferrite core 11 or a twin-holed ferrite core 41, the projections 14, 43 are disposed at the front end on the lower side of the ferrite core.

3. A ferrite core coil as claimed in claim 1, characterised in that with a cuboid, hollow cylindrical or twin-holed ferrite core 11, 31, 41, the projections lie in the horizontal symmetry plane of the ferrite core and that a printed circuit board 37 provides a recess 38 for accommodating the ferrite core and the conductor strips 39, which end below the coil tags 35 of the coil winding 34.

## Revendications

1. Bobine à noyau de ferrite avec plus deux raccords de bobine (17-19), dans laquelle les extrémités des fils de la bobine (16) conduisent aux contacts de bobine (17-19) sont enroulés autour de saillies (14, 15) se trouvant dans un plan, se trouvant sur le pourtour du noyau de ferrite (11) et dans laquelle les saillies (14, 15) ainsi que les extrémités des fils constituent les contacts de bobine (17-19), qui peuvent être reliés par soudage Reflow aux pistes conductrices (20-23) d'un circuit imprimé (25), bobine à noyau de ferrite de fente, caractérisée en ce que les saillies (14, 15) sont fabriquées d'une seule pièce avec le noyau de ferrite (11).

2. Bobine à noyau de ferrite selon la revendication 1, caractérisée en ce que dans le cas d'un noyau de ferrite de forme parallélépipédique (11) ou d'un noyau de ferrite à double perforation (41) les saillies (14, 43) sont disposées du côté frontal sur le côté inférieur du noyau de ferrite.

3. Bobine à noyau de ferrite selon la revendication 1, caractérisée en ce que, dans le cas d'un noyau de ferrite de forme parallélépipédique, d'un noyau de ferrite cylindrique creux ou d'un noyau de ferrite à double perforation (11, 31, 41) les saillies se trouvent dans le plan horizontal de symétrie du noyau de ferrite et en ce qu'un circuit imprimé (37) présente un évidement (39) pour recevoir le noyau de ferrite et des pistes conductrices (39) qui se terminent en-dessous des contacts de bobine (35) de l'enroulement de bobine (34).
